# EUROPEAN PATENT SPECIFICATION

(11) **EP 4 468 835 B1**
(45) Date of publication and mention of the grant of the patent: **15.04.2026**
(21) Application number: 22927249.7
(22) Date of filing: 08.09.2022
(51) Int. Cl.: H05K 7/20, H01L 23/40, H01L 23/36, H01L 23/48

(54) **HEAT-SINK FIXING STRUCTURE**
KÜHLKÖRPERBEFESTIGUNGSSTRUKTUR
STRUCTURE DE FIXATION DE DISSIPATEUR THERMIQUE

(30) Priority: 21.02.2022 JP 2022024713
(43) Date of publication of application: 27.11.2024
(73) Proprietor: JVCKENWOOD Corporation, Yokohama-shi, Kanagawa 2210022 (JP)
(72) Inventor: SUGIYAMA, Daisuke, Yokohama-shi, Kanagawa 221-0022 (JP)
(74) Representative: Schmidbauer, Andreas Konrad
(86) International application number: PCT/JP2022/033714
(87) International publication number: WO 2023/157355

(56) References cited:
- JP-A- 2003 289 190
- JP-A- 2015 082 597
- JP-U- S59 107 195
- US-A1- 2018 035 530

## Description

### Field

The present invention relates to a heat-sink fixing structure.

### Background

For example, in Patent Literature 1, a structure in which a heat sink is mounted on a substrate and a casing plate by fixing an electronic component soldered to the substrate to the heat sink with screws is described. A further similar system is described in Patent Literature 2.

### Citation List

### Patent Literature

Patent Literature 1: JP-A-2000-236185 Patent Literature 2: JP 2003 289190 A.

### Summary

### Technical Problem

Because it is difficult to obtain dimensional accuracy in positions of a casing plate, a screw-fixing portion of a heat sink, and a substrate to which an electronic component is soldered, if the heat sink is fixed with a rigid structure, a soldered part of the electronic component soldered to the substrate is prone to receive stress. When stress is applied to the soldered portion, there is a risk that a crack may occur in that portion.

An object of the present disclosure is to provide a heat-sink fixing structure that enables to reduce stress on a soldered portion of an electronic component.

### Solution to Problem

To achieve the above object, a heat-sink fixing structure according to one aspect of the present disclosure includes: a heat sink fixed to a main unit of an electronic component to which a leg portion is connected to a substrate by soldering; a mounting portion provided in a device main unit to which the substrate is fixed, the mounting portion having flexibility; and a joining member joining the heat sink and the mounting portion. Advantageous Effects of Invention

According to the present disclosure, it is possible to reduce stress on a soldered portion of an electronic component.

### Brief Description of Drawings

FIG. 1 is a perspective view illustrating a heat-sink fixing structure.
FIG. 2 is a partially-cut perspective view illustrating the heat-sink fixing structure.
FIG. 3 is a cross-section illustrating the heat-sink fixing structure.

### Description of Embodiments

Hereinafter, a form (hereinafter, embodiment) to implement the present disclosure will be explained in detail, referring to the drawings. Moreover, components in the embodiment include those easily thought of by person skilled in the art, those substantially identical, and those within a range of what is commonly understood as equivalents. Furthermore, the components disclosed in the embodiments described below can be combined appropriately.

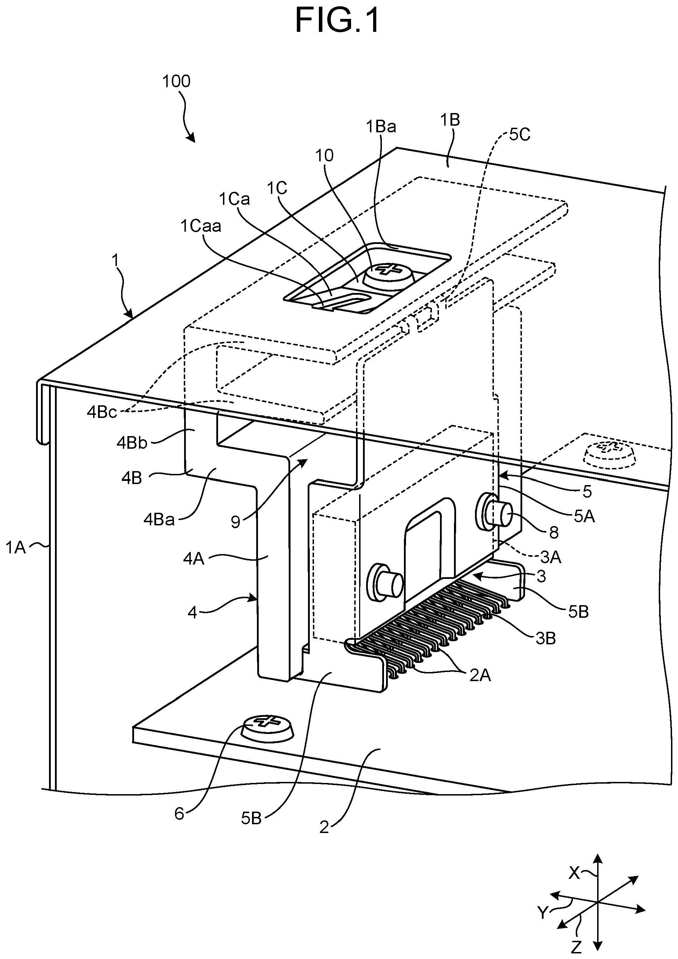

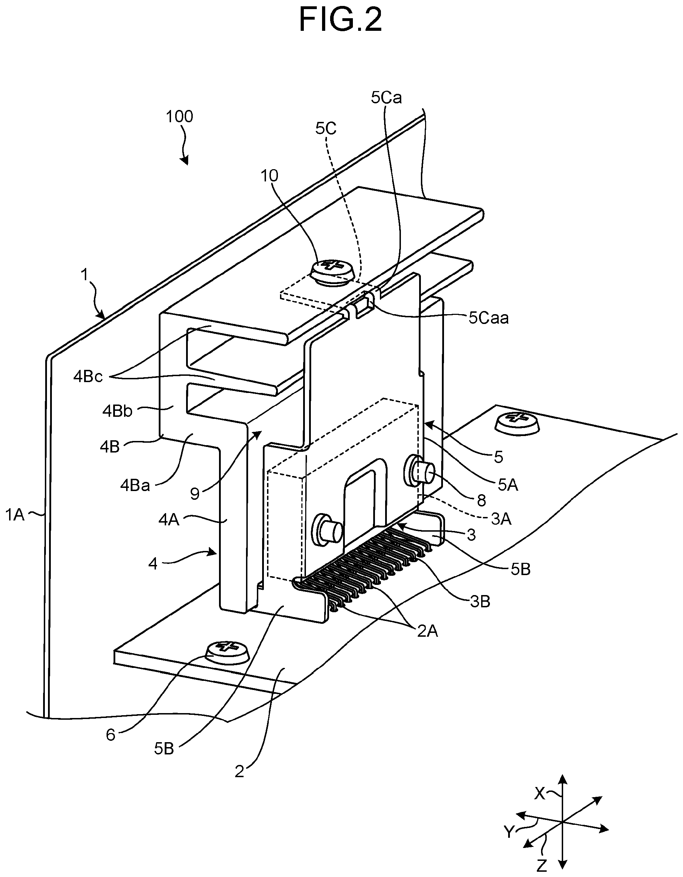

As illustrated in FIG. 1 to FIG. 3, a heat-sink fixing structure according to an embodiment is applied to an electronic device 100 installed in an interior of a vehicle. The electronic device 100 includes, for example, an audio visual (AV) integrated car navigation system.

The electronic device 100 includes a device main unit 1, a substrate 2, an electronic component 3, a heat sink 4, and a supporting member **5.**

The device main unit 1 is a casing that houses the substrate 2, the electronic component 3, the heat sink 4, and the supporting member 5, and includes plate members that surrounds in an up-down direction (X direction), a left-right direction (Y direction), and a front-rear direction (Z direction). In FIG. 1, as the plate members made of a metal plate, a side plate 1A in one direction in the left-right direction and an upper plate 1B in the up-down direction are illustrated, and other plate members are omitted. Moreover, on a front side of the device main unit 1, a display panel is arranged as the plate member. The up-down direction (X direction) is referred to as a vertical direction also, and a plane formed by combining the up-down direction (X direction) and the front-rear direction (Z direction) is referred to as vertical plane, and the left-right direction (Y direction) is referred to as a horizontal direction also, and a plane formed by combining the left-right direction (Y direction) and the front-rear direction (Z direction) is referred to as horizontal plane.

The substrate 2 is a printed circuit board and is formed in a plate shape, and arranged such that a plate surface is along the horizontal plane in the device main unit 1. The substrate 2 is fixed to a plate member along the horizontal plane, for example, a bottom plate or a middle plate not illustrated, in the device main unit with a screw 6.

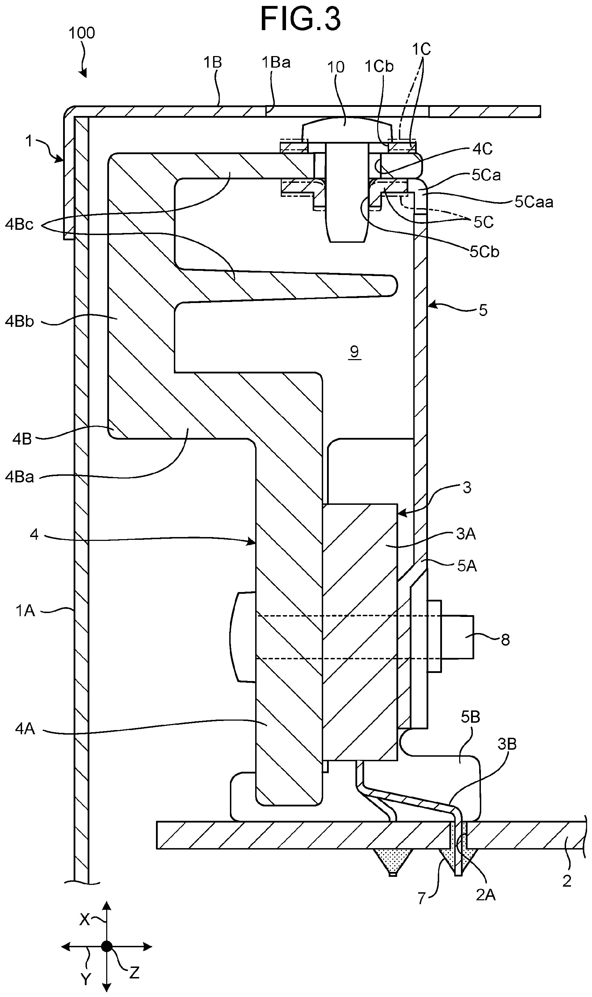

The electronic component 3 is an electronic device, such as an integrated circuit (IC), and is constituted of a main unit 3A in a rectangular shape, and a leg portion 3B extending outside the main unit 3A. In the electronic component 3, the leg portion 3B is inserted in a hole 2A of the substrate 2, to be soldered with solder 7 (refer to FIG. 3). In the embodiment, the electronic component 3 is configured such that the leg portion 3B is inserted in the up-down direction with respect to the hole 2A of the substrate 2 arranged along the horizontal plane.

The heat sink 4 is to dissipate heat of the electronic component 3, and is made of a highly thermally conductive material, such as aluminum alloy. The heat sink 4 includes a heat transferring portion 4A and a heat dissipating portion 4B. The heat transferring portion 4A is formed in a plate shape so as to be in contact with the main unit 3A of the electronic component 3 along its outer surface. The heat transferring portion 4A is formed in a plate shape extending in the up-down direction to have a vertical plane so as to be in contact with a vertical plane of the main unit 3A. The heat transferring portion 4A is fixed in contact with the main unit 3A with a screw 8. Therefore, to the heat transferring portion 4A, heat from the main unit 3A of the electronic component 3 is transferred. The heat dissipating portion 4B is arranged in continuous with an upper end portion of the heat transferring portion 4A. The heat dissipating portion 4B includes a horizontal portion 4Ba that bends in the horizontal direction from the upper end portion of the heat transferring portion 4A, a vertical portion 4Bb that bends upward from the end portion extending from the horizontal portion 4Ba, and a fin portion 4Bc that extends in the horizontal direction from a middle of extension of the vertical portion 4Bb and the extended end portion. Therefore, the heat dissipating portion 4B dissipates heat transferred from the heat transferring portion 4A from the horizontal portion 4Ba, the vertical portion 4Bb, and the fin portion 4Bc.

The supporting member 5 is to hold the electronic component 3, and is constituted of a metal plate. The supporting member 5 includes a fixing portion 5A and a supporting member 5B. The fixing portion 5A is formed in a plate shape through a drawing process so as to be in contact with the main unit 3A of the electronic component 3 along its outer surface. The fixing portion 5A is formed in a plate shape extending in the up-down direction to have a vertical plane so as to be in contact with a vertical plane of the main unit 3A in the embodiment. The fixing portion 5A is arranged to sandwich the main unit 3A with the heat transferring portion 4A of the heat sink 4, and is fixed in contact with the main unit 3A with the screw 8 fixing the heat transferring portion 4A. Moreover, the fixing portion 5A is arranged opposing a distal end portion that is an extension of the fin portion 4Bc of the heat dissipating portion 4B in the heat sink 4, and forms a space portion 9 that penetrates in the front-rear direction so as to close the distal end side of the fin portion 4Bc. The supporting member 5B is bent on both sides of the fixing portion 5A to enclose the main unit 3A from both sides. The supporting member 5B is configured such that its bottom portion abuts on the horizontal plane of the substrate 2, and a lower end of the heat transferring portion 4a of the heat sink 4 abuts thereon. Thus, the supporting member 5 makes the substrate 2 bear a load on the main unit 3A of the electronic component 3 and the heat sink 4, to support the main unit 3A and the heat sink 4. Moreover, because the supporting member 5 is made of a metal plate, heat of the main unit 3A of the electronic component 3 is transferred thereto.

For the electronic device 100 thus configured, the heat-sink fixing structure to fix the heat sink 4 includes a mounting portion 1C arranged in the device main unit 1, a connecting portion 5C that is arranged in the supporting member 5, and a joining member 10 that is constituted of a screw to join the heat sink 4, the mounting portion 1C, and the connecting portion 5C.

The mounting portion 1C is arranged in an upper plate 1B, which is the device main unit 1, in the present embodiment. The mounting portion 1C is formed by die-cutting a metal plate of the upper plate 1B. The mounting portion 1C is formed in a tongue-like shape extending in the horizontal direction inside an opening portion 1Ba from an edge of the opening portion 1Ba formed in the upper plate 1B. In the mounting portion 1C, a bending portion 1Ca having flexibility with a notch 1Caa is formed in a base portion extending from the edge of the opening portion 1Ba. The mounting portion 1C elastically deforms to bend in the vertical direction with the bending portion 1Ca as indicated by a dash-dot line in FIG. 3. Moreover, in the mounting portion 1C, a through hole 1Cb that pierces through in the vertical direction is formed in a distal end portion extending from the edge of the opening portion 1Ba. In the through hole 1Cb, a screw serving as the joining member 10 is inserted.

The connecting portion 5C is the supporting member 5, and is arranged in the fixing portion 5A in the embodiment. The connecting portion 5C is formed from a metal plate together with the fixing portion 5A. The connecting portion 5C is formed in a tongue-like shape extending in the horizontal direction by bending a distal end portion of the fixing portion 5A extending in an upper direction. In the connecting portion 5C, a bending portion 5Ca having flexibility with a notch 5Caa is formed in a bent base portion. The connecting portion 5C elastically deforms to bend in the vertical direction with the bending portion 5Ca as indicated by a dash-dot line in FIG. 3. Moreover, in the connecting portion 5C, a screw hole 5Cb that pierces through in the vertical direction is formed in a distal end portion extending in the horizontal direction. In the screw hole 5Cb, a screw serving as the joining member 10 is screwed.

In the heat sink 4, a through hole 4C that pierces through in the vertical direction is formed in the fin portion 4Bc at an uppermost position. In the through hole 4C, a screw that is the joining member 10 is screwed.

In this heat-sink fixing structure, an upper end portion of the heat sink 4 is fixed to the device main unit 1 by the joining member 10 through the mounting portion 1C. Therefore, the heat sink 4 fixed to the main unit 3A of the electronic component 3 is fixed to the device main unit 1 through the mounting portion 1C having flexibility. Moreover, in the heat-sink fixing structure, an upper end portion of the supporting member 5 is fixed to the device main unit 1 by the joining member 10 through the mounting portion 1C and the connecting portion 5C. Therefore, the supporting member 5 fixed to the main unit 3A of the electronic component 3 together with the heat sink 4 is fixed to the device main unit 1 through the mounting portion 1C having flexibility and the connecting portion 5C.

Not limited to the embodiment described above, the mounting portion 1C may be arranged in a side plate 1A, not the upper plate 1B. Moreover, not limited to the embodiment described above, it may have an arrangement such that the X direction is the horizontal direction, and the Y direction or the Z direction is the vertical direction in the drawings.

As described, the heat-sink fixing structure according to the embodiment includes the heat sink 4 that is fixed to the main unit 3A of the electronic component 3 to which the leg portion 3B is connected to the substrate 2 by solder, the mounting portion 1C with flexibility arranged in the device main unit 1 to which the substrate 2 is fixed, and the joining member 10 that joins the heat sink 4 and the mounting portion 1C.

According to this heat-sink fixing structure, the heat sink 4 fixed to the main unit 3A of the electronic component 3 is joined to the device main unit 1 to which the substrate 2 is fixed with the leg portion 3B of the electronic component 3 soldered thereto, through flexure of the mounting portion 1C arranged in the device main unit 1. Therefore, even if there is an error in positioning accuracy in connecting the electronic component 3 to the substrate 2 with solder, positioning accuracy in fixing the heat sink 4 to the electronic component 3, or positioning accuracy in fixing the substrate 2 to the device main unit 1 at joining, the heat-sink fixing structure according to the embodiment enables to join the heat sink 4 with the device main unit 1 absorbing the error with flexure of the mounting portion 1C. Therefore, the heat-sink fixing structure according to the embodiment can reduce stress on the soldered portion of the electronic component 3 caused by an error in the positioning accuracy.

Moreover, in the heat-sink fixing structure according to the embodiment, the mounting portion 1C has flexibility along the vertical direction in which the leg portion 3B of the electronic component 3 extends toward the substrate 2.

According to this heat-sink fixing structure, in the soldered portion, although a crack is likely to occur due to stress in the direction in which the leg portion 3B extends and inserted in the hole 2A of the substrate 2, stress on the soldered portion in a direction in which a crack is likely to occur can be reduced by causing flexure of the mounting portion 1C in that direction. Therefore, the heat-sink fixing structure according to the embodiment can prevent occurrence of cracks in the soldered portion.

Moreover, in the heat-sink fixing structure according to the embodiment includes the supporting member 5 that supports the main unit 3A of the electronic component 3, and the supporting member 5 includes the connecting portion 5C with flexibility joined to the mounting portion 1C together with the heat sink 4 by the joining member 10.

The supporting member 5 is fixed to the main unit 3A of the electronic component 3, if there is an error in positioning accuracy in connecting the electronic component 3 to the substrate 2 with solder, positioning accuracy in fixing the supporting member 5 to the electronic component 3, or positioning accuracy in fixing the substrate 2 to the device main unit 1, there is a risk of generating stress on the soldered portion of the electronic component 3. In this regard, according to heat-sink fixing structure of the embodiment, because the supporting member 5 is joined to the mounting portion 1C together with the heat sink 4 with the joining member 10 through and the connecting portion 5C having flexibility, the supporting member 5 can be joined to the device main unit 1 together with the heat sink 4 absorbing the error with flexure of the connecting portion 5C and the mounting portion 1C. Therefore, the heat-sink fixing structure according to the embodiment can reduce stress on the soldered portion of the electronic component 3 due to the error in the positional accuracy. In addition, in this heat-sink fixing structure, the joining member 10 can be used for joining both the mounting portion 1C and the connecting portion 5C, enabling to prevent increase of the number of parts.

Furthermore, in the heat-sink fixing structure according to the embodiment, the heat sink 4 (the fin portion 4Bc at the uppermost position) is sandwiched between the mounting portion 1C and the connecting portion 5C, and the joining member 10, which is a screw, is inserted from the mounting portion 1C through the heat sink 4, to be screwed into the screw hole 5Cb of the connecting portion 5C. By thus structuring, the heat-sink fixing structure according to the embodiment enables to prevent occurrence of a crack in the heat sink 4 that can be formed by forming a screw hole in the heat sink 4 having low rigidity made of aluminum alloy or the like. In addition, in the heat-sink fixing structure of the embodiment, by joining the heat sink 4 sandwiching between the mounting portion 1C and the connecting portion 5C, joining to the mounting portion 1C by forming a screw hole in the heat sink 4 and bringing the heat sink 4 and the mounting portion 1C into a contact state can be achieved at once, thereby ensuring heat dissipation performance.

Moreover, in the heat-sink fixing structure according to the embodiment, the connecting portion 5C has flexibility along the vertical direction in which the leg portion 3B of the electronic component 3 extends toward the substrate 2.

As described above, a crack is likely to occur in the soldered portion because stress is applied in the direction in which the leg portion 3B extends to be inserted into the hole 2A of the substrate 2, and by generating bend in the connecting portion 5C in that direction, stress on the soldered portion in the direction likely to cause a crack can be reduced. Therefore, the heat-sink fixing structure according to the embodiment enables to prevent occurrence of a crack in the soldered portion.

Furthermore, in the heat-sink fixing structure according to the embodiment, the main unit 3A of the electronic component 3 is sandwiched between the heat sink 4 and the supporting member 5 to be fixed, and the space portion 9 that penetrates in a predetermined direction is arranged between the heat sink 4 and the supporting member 5.

According to the heat-sink fixing structure of the embodiment, using the space portion 9 that penetrates through in the predetermined direction as a channel for heat dissipation, the heat dissipation effect can be improved.

In the heat-sink fixing structure according to the embodiment, when joining the heat sink 4 and the mounting portion 1C, a gap is provided between the heat sink 4 and the mounting portion 1C as indicated by a dot and dash line in FIG. 3, and they are joined to eliminate the gap with the joining member 10. Moreover, in the heat-sink fixing structure according to the embodiment, when joining the heat sink 4 and the connecting portion 5C, a gap is provided between the heat sink 4 and the connecting portion 5C, and they are joined to eliminate the gap with the joining member 10. According to the heat-sink fixing structure of the embodiment, by thus structuring, an absorption rate of a dimensional error can be increased.

Furthermore, in the heat-sink fixing structure according to the embodiment, the joining direction with the joining member 10 is along the vertical direction perpendicular to a plate surface of the substrate 2. According to this heat-sink fixing structure, the absorption rate of the dimensional error can be increased by matching the joining direction with the joining member 10 with a direction easy for the substrate 2 to bend.

### Industrial Applicability

The heat-sink fixing structure of the present disclosure enable to reduce stress on a soldered portion of an electronic component.

### Reference Signs List

- 1: Device main unit
- 1C: Mounting portion
- 2: Substrate
- 3: Electronic component
- 3A: Main unit
- 3B: Leg portion
- 4: Heat sink
- 5: Supporting member
- 5C: Connecting portion
- 9: Space portion
- 10: Joining member

## Claims

1. A heat-sink fixing structure comprising:
a heat sink (4) fixed to a main unit (3A) of an electronic component (3) to which a leg portion (3B) is connected to a substrate (2) by soldering;
a mounting portion (1C) provided in a device main unit (1) to which the substrate (2) is fixed, the mounting portion (1C) having flexibility; and
a joining member (10) joining the heat sink (4) and the mounting portion (1C).

2. The heat-sink fixing structure according to claim **1,** wherein
the mounting portion (1C) has flexibility along a direction in which the leg portion (3B) of the electronic component (3) extends toward the substrate (2).

3. The heat-sink fixing structure according to claim 1 or 2, comprising
a supporting member (5) supporting the main unit (3A) of the electronic component (3), wherein
the supporting member (5) includes a connecting portion (5C) joined to the mounting portion (1C) together with the heat sink (4) with the joining member (10), the connecting portion (5C) having flexibility.

4. The heat-sink fixing structure according to claim 3, wherein
the heat sink (4) is sandwiched between the mounting portion (1C) and the connecting portion (5C), and
the joining member (10) is inserted from the mounting portion (1C) through the heat sink (4), to be joined with the connecting portion (5C).

5. The heat-sink fixing structure according to claim 3 or 4, wherein
the main unit (3A) of the electronic component (3) is fixed by being sandwiched between the heat sink (4) and the supporting member (5), and a space portion that penetrates in a predetermined direction is provided between the heat sink (4) and the supporting member (5).

## Patentansprüche

1. Kühlkörper-Fixierungsaufbau, aufweisend:
einen Kühlkörper (4), der an einer Haupteinheit (3A) einer elektronischen Komponente (3) fixiert ist, an der ein Schenkelteil (3B) durch Löten mit einem Substrat (2) verbunden ist,
einen Montageteil (1C), der in einer Gerätehaupteinheit (1), an der das Substrat (2) fixiert ist, vorgesehen ist, wobei der Montageteil (1C) eine Flexibilität aufweist, und
ein Verbindungsglied (10), das den Kühlkörper (4) mit dem Montageteil (1C) verbindet.

2. Kühlkörper-Fixierungsaufbau nach Anspruch 1, wobei:
der Montageteil (1C) eine Flexibilität entlang einer Richtung, in der sich der Schenkelteil (3B) der elektronischen Komponente (3) zu dem Substrat (2) erstreckt, aufweist.

3. Kühlkörper-Fixierungsaufbau nach Anspruch 1 oder 2, der aufweist:
ein Halteglied (5), das die Haupteinheit (3A) der elektronischen Komponente (3) hält, wobei:
das Halteglied (5) einen Verbindungsteil (5C) umfasst, der zusammen mit dem Kühlkörper (4) mit dem Montageteil (1C) mittels des Verbindungsglieds (10) verbunden wird, wobei der Verbindungsteil (5C) eine Flexibilität aufweist.

4. Kühlkörper-Fixierungsaufbau nach Anspruch 3, wobei:
der Kühlkörper (4) zwischen dem Montageteil (1C) und dem Verbindungsteil (5C) eingeschlossen wird, und
das Verbindungsglied (10) von dem Montageteil (1C) durch den Kühlkörper (4) eingesteckt wird, um mit dem Verbindungsteil (5C) verbunden zu werden.

5. Kühlkörper-Fixierungsaufbau nach Anspruch 3 oder 4, wobei:
die Haupteinheit (3A) der elektronischen Komponente (3) fixiert wird, indem sie zwischen dem Kühlkörper (4) und dem Halteglied (5) eingeschlossen wird, wobei ein Zwischenraum, der sich in einer vorbestimmten Richtung erstreckt, zwischen dem Kühlkörper (4) und dem Halteglied (5) vorgesehen ist.

## Revendications

1. Structure de fixation de dissipateur thermique comprenant :
un dissipateur thermique (4) fixé à une unité principale (3A) d'un composant électronique (3) auquel une partie de patte (3B) est connectée à un substrat (2) par soudure ;
une partie de montage (1C) prévue dans une unité principale d'un dispositif (1) à laquelle le substrat (2) est fixé, la partie de montage (1C) étant flexible ; et
un élément de liaison (10) reliant le dissipateur thermique (4) et la partie de montage (1C).

2. Structure de fixation du dissipateur thermique selon la revendication 1, dans laquelle
la partie de montage (1C) est flexible dans une direction dans laquelle la partie de patte (3B) du composant électronique (3) s'étend vers le substrat (2).

3. Structure de fixation du dissipateur thermique selon la revendication 1 ou 2, comprenant
un élément de support (5) supportant l'unité principale (3A) du composant électronique (3), dans laquelle
l'élément de support (5) comporte une partie de connexion (5C) reliée à la partie de montage (1C) ainsi qu'au dissipateur thermique (4) avec l'élément de liaison (10), la partie de connexion (5C) étant flexible.

4. Structure de fixation du dissipateur thermique selon la revendication 3, dans laquelle
le dissipateur thermique (4) est interposé entre la partie de montage (1C) et la partie de connexion (5C), et
l'élément de liaison (10) est inséré depuis la partie de montage (1C) à travers le dissipateur thermique, pour être relié à la partie de connexion (5C).

5. Structure de fixation du dissipateur thermique selon la revendication 3 ou 4, dans laquelle
l'unité principale (3A) du composant électronique (3) est fixée en étant interposée entre le dissipateur thermique (4) et l'élément de support (5) et une partie d'espace qui pénètre dans une direction prédéterminée est prévue entre le dissipateur thermique et l'élément de support (5).
